(19) Europäisches Patentamt
European Patent Office
Office européen des brevets

(11) Veröffentlichungsnummer : **0 323 485 B1**

# (12) EUROPÄISCHE PATENTSCHRIFT

(45) Veröffentlichungstag der Patentschrift :
26.08.92 Patentblatt 92/35

(51) Int. Cl.$^5$ : **G06F 15/60, G09B 29/10**

(21) Anmeldenummer : **88904495.4**

(22) Anmeldetag : **04.06.88**

(86) Internationale Anmeldenummer :
**PCT/DE88/00329**

(87) Internationale Veröffentlichungsnummer :
**WO 88/09974 15.12.88 Gazette 88/27**

(54) **VERFAHREN UND VORRICHTUNG ZUR BESTIMMUNG EINER FAHRTROUTE ZWISCHEN EINEM STARTPUNKT UND EINEM ZIELPUNKT.**

(30) Priorität : **06.06.87 DE 3719017**

(43) Veröffentlichungstag der Anmeldung :
**12.07.89 Patentblatt 89/28**

(45) Bekanntmachung des Hinweises auf die Patenterteilung :
**26.08.92 Patentblatt 92/35**

(84) Benannte Vertragsstaaten :
**AT BE CH DE FR GB IT LI LU NL SE**

(56) Entgegenhaltungen :
**GB-A- 2 139 794**

(56) Entgegenhaltungen :
**Bosch Technische Berichte, volume 8, No 1/2, 1986, E.P.Neukirchner et al.: "EVA- ein autarkes Ortungs- und Navigatationsystemfür Landfahrzeuge", pages 7-14, see page 10, column 1, lines 14-22;page 12, column 2, lines 27-35; line 49-page 13, column 1, line5; figure 2-4**
**AFIPS Conf.Proc. National Computer Conference, 9-12 July 1984, Las Vegas, Nevada (US) M.Sugie et al.:"Carguide-on-boardcomputer for automobile route guidance" pages 695-706, see page 699,column 2, lines 6-10;page 703, column 1,lines 5-9; figure 4**
**Funkschau, No 4, February 1985 (München, DE) "Informieren und leiten" pages 33-36, see page 35, column 2, lines 16-27**

(73) Patentinhaber : **ROBERT BOSCH GMBH**
**Postfach 30 02 20**
**W-7000 Stuttgart 30 (DE)**

(72) Erfinder : **NEUKIRCHNER, Ernst-Peter**
**Sandkamp 16**
**W-3200 Hildesheim (DE)**
Erfinder : **SCHLÖGL, Dietmar**
**Lange Halbe 19**
**W-3226 Sibbesse (DE)**

EP 0 323 485 B1

## Beschreibung

Die Erfindung betrifft ein Verfahren zur Bestimmung einer Fahrtroute zwischen einem Startpunkt und einem Zielpunkt nach dem Oberbegriff des Anspruchs 1.

Unter der Bezeichnung EVA (Elektronischer Verkehrslotse für Autofahrer) wird ein autarkes Ortungs- und Navigationssystems für Landfahrzeuge entwickelt. Die Berechnung eines optimalen Weges von einem beliebigen Startpunkt zu einem frei wählbaren Zielpunkt stützt sich auf ein digital gespeichertes Straßennetz. Je größer die Entfernung zwischen dem Zielpunkt und dem Startpunkt ist, desto vielfältiger sind die Möglichkeiten, unter Benutzung des gespeicherten Straßennetzes dorthin zu gelangen. Diese Wege sind nicht gleichwertig und der optimale Weg muß deshalb durch Berechnung ermittelt werden. Wegen der bei umfangsreichen Berechungen benötigten Rechenzeit kann es geschehen, daß die Ergebnisse dem Fahrer nicht rechtzeitig zur Verfügung stehen, da er bereits eine Straßenabzweigung, an der er hätte abbiegen müssen, verfehlt hat. In Bosch Technische Berichte, Vol. 8, Nr. 1/2, 1986, E.P. Neukirchner, W. Zechnall "EVA-Ein autarkes Ortungs- und Navigationssystem für Landfahrzeuge", Seiten 7 bis 14 ist das bereits erwähnte EVA Systemkonzept beschrieben. Die Navigations-, Ortungs- und Routenfunktionen stützen sich hierbei auf die im Fahrzeug mitgeführte digitale Netzabbildung, die die Datenbasis des Systems darstellt. Hierbei ist das gesamte Netz in seinem topologischen Zusammenhang dargestellt. Knoten und Kanten des Graphen werden durch ein Numerierungssystem identifiziert. Zur Navigation werden die möglichen Wege von einer Netzkante zu jeder anderen mit ihr verbundenen Kante berechnet, um so den günstigsten Weg zu ermitteln. Bei einer großen Datenbasis gestaltet sich dies recht aufwendig, so daß eine relativ hohe Rechenzeit benötigt wird, auch wenn die Daten als hierarchisch aufgebaute Teilbereiche gespeichert sind.

Durch die Erfindung ist auch bei ausgedehnten Straßennetzen schnell und sicher die optimale Fahrtroute zu ermitteln. Die Erfindung beruht dabei auf der Überlegung, daß der Verkehr in der Nähe des Startpunktes und des Zielpunktes über Nebenstraßen geführt wird und die größeren Entfernungen über Haupt- und Fernstraßen zurückgelegt werden. Dabei fassen die Haupt- und Fernstraßen die Verkehrsströme aus verschiedenen Gebieten zusammen. Werden bei einem größeren Gebiet nur die den Fernverkehr führenden Straßen berücksichtigt, so führt dies zu einem Straßennetz mit gröberer Maschendichte, die weniger Variationsmöglichkeiten auf unterschiedlichen Strecken bietet und dadurch auch weniger Rechenzeit beim fahrzeugeigenen Rechner benötigt.

Bei der Aufteilung des Straßennetzes in Ebenen wird zweckmäßig so vorgegangen, daß jedes Gebiet etwa die gleiche Anzahl von Variationsmöglichkeiten bei der Streckenfindung bietet und somit die gleiche Anzahl von Speicherplätzen im Rechner belegt und entsprechend die gleiche Rechenzeit erfordert. Daneben werden aber auch die geographischen Gegebenheiten berücksichtigt, insbesondere ob zwischen den einzelnen Gebieten mehrere unterschiedliche Übergänge bestehen.

Auch bei der Zusammenfassung mehrerer Gebiete der unteren oder einer untergeordneten Ebene zu einem Gebiet einer höheren Ebene wird nach den genannten Kriterien vorgegangen. Auf diese Weise können mehrere Ebenen gebildet werden, die auch ländergrenzenübergreifend eine Fahrtroutenbestimmung ermöglichen.

Besonders zweckmäßig ist es, wenn die Maschen aus Straßen und Knoten gebildet werden, wobei die Knoten in der unteren Ebene Straßenverzweigungen und in der höheren Ebene Teilgebiete der unteren oder nächstunteren Ebene darstellen. Auf diese Weise läßt sich die Systematik jeweils beim Übergang von einer zur anderen Ebene fortsetzen und die Fahrtroutenbestimmung nach dem selben Algorithmus durchführen. Zweckmäßig werden den Straßen und Knoten Widerstandswerte zugeordnet, die z.B. bei Fernstraßen wegen der geringen Entfernung und der kurzen Fahrzeit niedrig angesetzt und bei Nebenstraßen mit vielen Kurven und Ortsdurchfahrten wegen der langen Wege und der langen Fahrzeit hoch angesetzt werden. Bei der Auswahl der Fahrtroute werden deshalb bevorzugt diejenigen Straßen berücksichtigt, welche den niedrigsten Widerstandswert bieten.

Bei der Bestimmung einer optimalen Fahrtroute müssen unterschiedliche Kriterien berücksichtigt werden, um bei allen Konstellationen des Startpunktes und des Zielpunktes zu günstigen Ergebnissen zu gelangen. So wird zweckmäßig bei Lage des Startpunktes und Zielpunktes im selben Teilgebiet versucht, eine Fahrtroute in diesem Teilgebiet zu bestimmen. Ist dies nicht möglich, wird versucht über ein angrenzendes Teilgebiet zum Ziel zu gelangen. Diese Vorgänge spielen sich noch in derselben Ebene ab.

Liegen Startpunkt und Zielpunkt weit auseinander, so werden dagegen die Hauptübergänge zwischen diesen Teilgebieten ermittelt, in der höheren Ebene die Übergangswiderstandsmatrizen gebildet und in der niedrigen Ebene diese mit den Widerstandswerten zwischen dem Startpunkt und den Übergängen des Startgebietes verknüpft. Für eine Optimierung wird anschließend auch noch ein angrenzendes Teilgebiet als Leitgebiet berücksichtigt, um z.B. über eventuelle vorhandene Nebenstrecken noch eine abkürzende Zuführung zu den Fernstraßen zu ermöglichen.

Die Erfindung betrifft ferner eine Vorrichtung zur Bestimmung einer Fahrtroute zwischen einem Startpunkt und einem Zielpunkt.

Diesbezüglich liegt ihr die Aufgabe zugrunde, eine Vorrichtung zu schaffen, welche auch bei größeren Straßennetzen eine schnelle und sichere Fahrtroutenbestimmung ermöglicht. Diese Aufgabe wird bei einer Vorrichtung nach dem Oberbegriff des Anspruchs 1 durch die im kennzeichnenden Teil angegebenen Merkmale gelöst.

Durch die Abspeicherung der verschiedenen Ebenen in unterschiedlichen Plätzen des Festwertspeichers wird erreicht, daß die Daten beim Übergang von einer zur anderen Ebene unmittelbar in den Arbeitsspeicher überführt werden können und dort für Berechnungen zur Verfügung stehen. Die Daten des Straßennetzes in den unterschiedlichen Ebenen brauchen also nicht aus einer gemeinsamen Datei gesondert berechnet zu werden.

Weiterbildungen und vorteilhafte Ausführungsformen der Erfindung ergeben sich aus den weiteren Ansprüchen, der Beschreibung und der Zeichnung, die ein Ausführungsbeispiel des Gegenstands der Erfindung veranschaulicht.

In der Zeichnung zeigen:

Fig. 1 ein Straßennetz eines größeren Gebietes auf der unteren Ebene und einer nächsthöheren Ebene,

Fig. 2 ein Straßennetz desselben Gebietes auf einer weiteren höheren Ebene,

Fig. 3 eine Darstellung des Gebietes aus einer weiteren höheren Ebene,

Fig. 4 ein Flußdiagramm zur Veranschaulichung eines bevorzugten Verfahrensablaufs,

Fig. 5 einen Ausschnitt aus einem Straßennetz, bei dem ein Zielpunkt nicht unmittelbar vom Startpunkt aus erreichbar ist,

Fig. 6 ein Straßennetz eines Gebietes zur Erläuterung des Verfahrensablaufs,

Fig. 7 ein Straßennetz des selben Gebietes auf einer nächsthöheren Ebene,

Fig. 8 eine Darstellung des Ford-Moore-Algorithmus,

Fig. 9 eine Tabelle zur Veranschaulichung des Ford-Moore-Algorithmus,

Fig. 10 einen Ausschnitt aus einem Straßennetz mit einem Stadtbereich und einem Fernstraßenbereich,

Fig. 11 eine Darstellung einer Fahrtroutenkorrektur, und

Fig. 12 ein Blockschaltbild einer erfindungsgemäßen Vorrichtung.

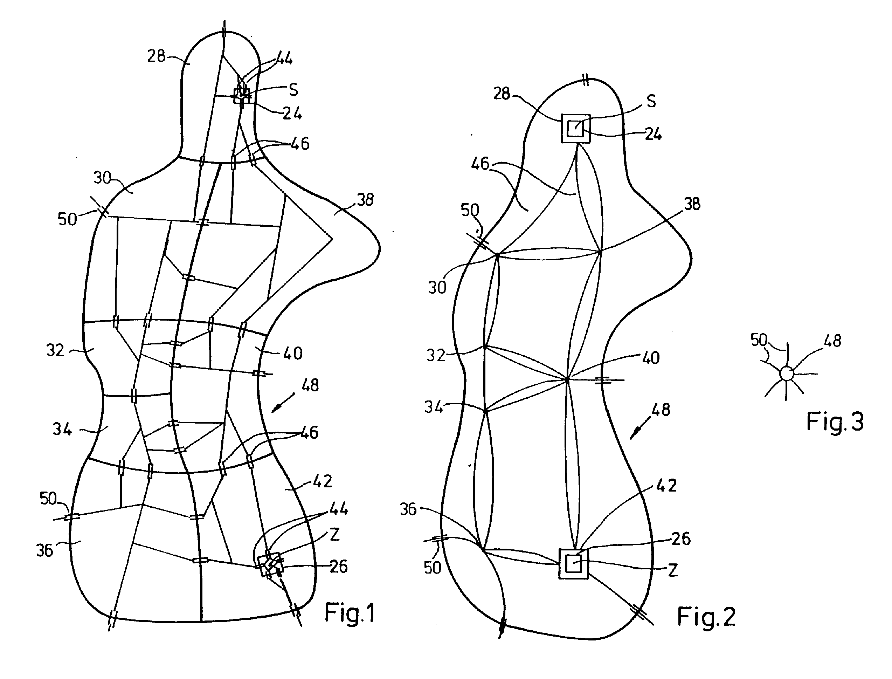

In Fig. 1 ist das Straßennetz eines größeren Gebietes, z.B. von der Größe der Bundesrepublik Deutschland dargestellt. Das Straßennetz ist in Teilgebiete aufgeteilt, von denen zwei Teilgebiete 24 und 26 in der unteren Ebene dargestellt sind. Auf die Wiedergabe weiterer Teilgebiete in der unteren Ebene wurde aus Gründen der Übersichtlichkeit verzichtet. In der nächsthöheren Ebene sind größere, grobmaschigere Teilgebiete 28...42 gezeigt. Jedes dieser Teilgebiete umfaßt widerum mehrere kleinere nicht dargestellte Teilgebiete der unteren Ebene.

An den gemeinsamen Grenzen zweier Teilgebiete sind Übergänge ausgewiesen. In der unteren Ebene handelt es sich um Übergänge 44, in der nächsthöheren Ebene um Übergänge 46. Die Auswahl der Teilgebiete wird nach der lokalen Maschendichte des tatsächlichen Verkehrsnetzes unter Berücksichtigung von vorhandenen Verbindungsstraßen getroffen. In Städten wird die Fläche eines Teilgebietes sehr klein, auf einem dünnbesiedelten Landgebiet sehr groß sein.

In Fig. 2 ist das Straßennetz desselben Gebietes wie in Fig. 1 auf einer weiteren höheren Ebene dargestellt. Aus den in Fig. 1 noch als räumlich ausgedehnt dargestellten Teilgebieten 28...42 sind Knoten gebildet worden. Die Verbindungen zwischen den Knoten werden durch Verbindungsstraßen 46 dargestellt, welche den Übergängen 46 in Fig. 1 entsprechen. Aus dem Vergleich der Darstellungen ist bereits die Systematik erkennbar, mit der die Aufteilung des Straßennetzes in Teilgebiete in unterschiedlichen Ebenen erfolgt. Zur Vervollständigung wird noch auf Fig. 3 verwiesen, bei der das gesamte Gebiet 48 aus Fig. 1 und Fig. 2 beim Übergang in eine weitere höhere Ebene in einen Knoten umgewandelt wird, aus dem nur noch Übergänge 50 zu Nachbarstaaten hinausführen.

In dem Straßennetz werden den einzelnen Straßen und Verzweigungen bzw. Verbindungen und Knoten Widerstandswerte zugeordnet. Diese Widerstandswerte kennzeichnen z.B. die Weglänge, die erforderliche Fahrzeit oder die mittlere Verkehrsdichte. Bei einem niedrigen Widerstandswert wird die betreffende Straße oder Verzweigung bzw. der Knoten oder die Verbindung bevorzugt zur Routenbestimmung herangezogen. Bei einem hohen Widerstandswert wird sie erst dann berücksichtigt, wenn andere Routenführungen noch ungünstiger sind.

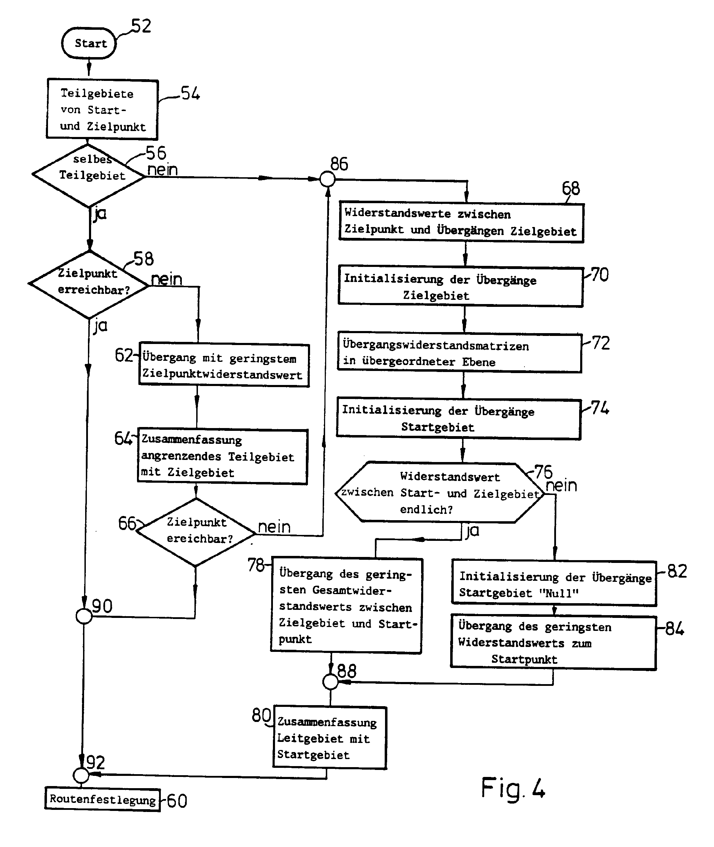

Da das erfindungsgemäße Verfahren bei beliebigen Konstellationen von Startpunkt und Zielpunkt zu optimalen Ergebnissen führen soll, sind mehrere Fallunterscheidungen zu treffen. Diese beziehen sich im wesentlichen auf die Frage, ob eine Verbindung in derselben Ebene oder in einer höheren Ebene bestimmt werden muß. Ein Flußdiagramm einer bevorzugten Ausführungsform, das diese Kriterien berücksichtigt, ist in Fig. 4 dargestellt.

Ausgehend vom Start 52 des Verfahrens werden zunächst in 54 die Teilgebiete bestimmt, in denen der Startpunkt und der Zielpunkt gelegen sind. Dann wird in 56 unterschieden, ob sie im selben Teilgebiet liegen. Ein einfacher Fall liegt vor, wenn dies zutrifft. Dann wird nämlich in 58 unterschieden, ob der Zielpunkt vom Startpunkt innerhalb desselben Teilgebietes erreichbar ist oder nicht. Bei einer Ja-Entscheidung liegt der einfachste Fall vor und die Route kann dann unmittelbar festgelegt werden.

Anders ist zu verfahren, wenn der Zielpunkt nicht vom Startpunkt aus in demselben Teilgebiet erreichbar ist. Dann wird in 62 der Übergang mit dem geringsten Widerstandswert vom Zielpunkt bestimmt. Anschließend werden in 64 das Teilgebiet, das an diesen Übergang angrenzt, und das den Startpunkt und den Zielpunkt enthaltende Teilgebiet zusammengefaßt. In 66 wird unterschieden, ob der Zielpunkt nun vom Startpunkt aus erreichbar ist. Trifft dies zu, so wird in 60 die Route festgelegt. Die Zusammenführung der Ja-Entscheidungen aus 58 und 66 erfolgt in der Additionsstelle 90.

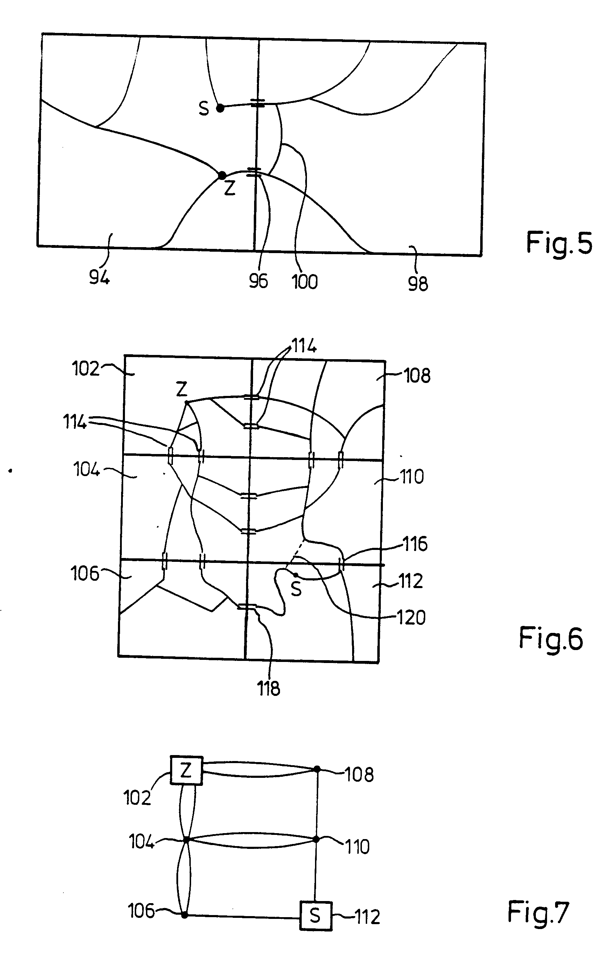

Der vorbeschriebene Unterfall ist in Fig. 5 erläutert. Dort besteht keine direkte Verbindung zwischen dem Startpunkt S und dem Zielpunkt Z im Teilgebiet 94. Es wird nun der Übergang mit dem geringsten Widerstandswert vom Zielpunkt Z bestimmt. Dies ist der Übergang 96. Das an diesem Übergang 96 angrenzende Teilgebiet 98 wird nun mit dem Teilgebiet 94 zusammengefaßt. Bei der nächsten Entscheidung, ob eine Verbindungsmöglichkeit besteht, wird aufgrund der Straße 100 nun die Entscheidung bejaht und die Fahrtroute festgelegt.

Ist, wieder bezugnehmend auf Fig. 4 jedoch eine Verbindung noch nicht möglich, so erfolgt über die Additionsstelle 86 eine gemeinsame Weiterbehandlung des Verfahrensablaufs mit der Nein-Entscheidung in 56, bei der der Startpunkt und der Zielpunkt in unterschiedlichen Teilgebieten liegen. In diesem Fall werden in 68 die Widerstandswerte vom Zielpunkt zu den Übergängen des Zielgebietes bestimmt. Dann werden in 70 die Übergänge mit den Zielpunkt-Widerstandswerten initialisiert.

Nun erfolgt der Übergang in die nächsthöhere Ebene. In 72 werden die Übergangswiderstandsmatrizen in dem Straßennetz der nächsthöheren Ebene bestimmt. Anschließend werden in 74 die Übergänge des Startgebietes mit dem Zielgebiet-Widerstandswerten initialisiert.

Nun erfolgt wieder der Übergang in die untere Ebene. In 76 wird unterschieden, ob der Widerstandswert zwischen dem Startpunkt und dem Zielgebiet endlich ist. Ist das der Fall, wird in 78 der Übergang bestimmt, welcher den geringsten Gesamtwidetstandswert zwischen dem Zielgebiet und dem Startpunkt besitzt. Danach wird in 80 das Teilgebiet, welches an diesen Übergang angrenzt (Leitgebiet) mit dem Startgebiet zusammengefaßt und in 80 die Route festgelegt. Zur Zusammenführung der Verfahrensflüsse dient in diesem Fall die Additionsstelle 92.

Der vorbeschriebene Verfahrensablauf ist in Fig. 6 und 7 verdeutlicht. Hier ist noch einmal ein Ausschnitt aus einem Straßennetz mit Teilgebieten 102 bis 112 dargestellt. Es werden also zunächst die Widerstandswerte an den Übergängen 114 bestimmt und diese mit den Zielpunkt-Widerstandswerten initialisiert. Dann erfolgt anhand des Straßennetzes, wie es Fig. 7 zeigt, die Bestimmung der Übergangswiderstandsmatrizen. Anschließend werden die Übergänge (116,118) des Startgebietes mit Zielgebiets-Widerstandswerten initialisiert.

Der Widerstandswert zwischen dem Startpunkt und dem Zielgebiet ist im vorliegenden Fall endlich. Bei Bestimmung des Überganges mit dem geringsten Gesamtwiderstandswert ergibt sich der Übergang 116. Das an diesen Übergang anschließende Teilgebiet 110 wird zum Leitgebiet L. Da diese beiden Teilgebiete 110 und 112 nun zusammengefaßt werden, kann die Routenbestimmung auch Nebenstrecken einschließen, die bei den Hauptübergängen 116 und 118 in der nächsthöheren Ebene nicht berücksichtigt sind. Es wird deshalb, wie Fig. 6 zeigt, die gestrichelte Straße 120 mit in die Routenbestimmung einbezogen.

Ist, unter erneuter Bezugnahme auf Fig. 4, der Widerstandswert zwischen dem Startpunkt und dem Zielgebiet nicht endlich, wird von 76 nach 82 verzweigt und dort die Übergänge des Startgebietes mit Null initialisiert. Danach erfolgt in 84 die Bestimmung des Überganges mit dem geringsten Widerstandswert vom Startpunkt. Danach wird unter Verknüpfung des Verfahrensflusses durch die Additionsstelle 88 mit dem in 80 beschriebenen Verfahrensschritt fortgefahren, womit alle in Frage kommenden Variationen beim Durchlaufen des Verfahrens erläutert sind.

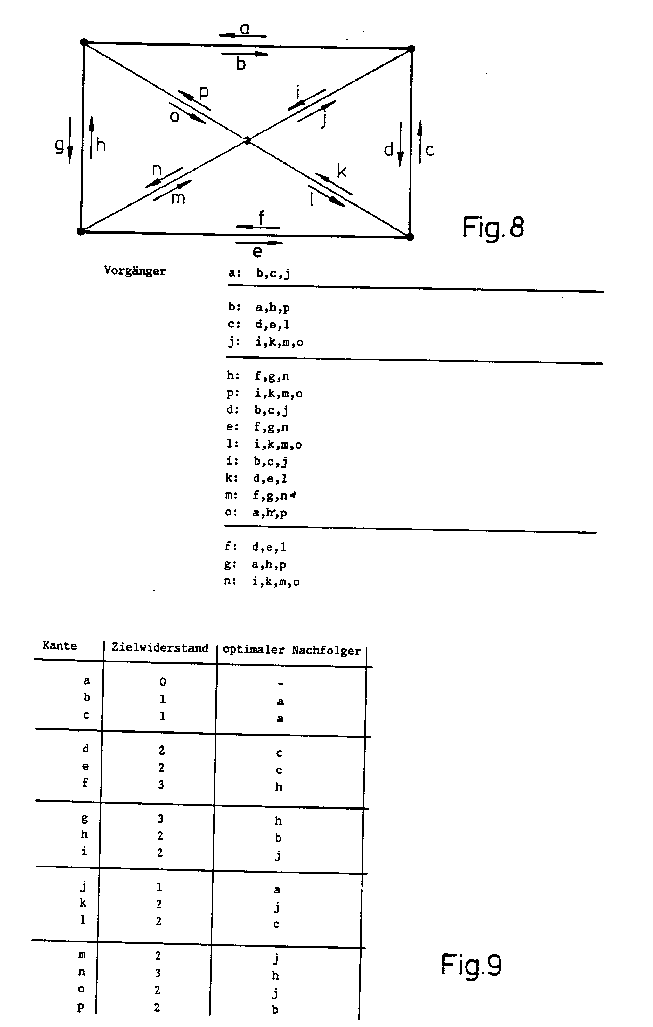

Fig. 8 zeigt ein Netzwerk, anhand dessen ein für die Berechnung des Straßennetzes möglicher Algorithmus, nämlich der umgekehrte Ford-Moore-Algorithmus erläutert wird. Zwischenergebnisse bei Anwendung des Algorithmus sind in Fig. 9 dargestellt.

Das abgebildete Netzwerk stellt eine Netzbeschreibung mit Informationen über die Vermaschung der Netzkanten mit den Knoten und Informationen über Verknüpfungslängen, z.B. der Zeitbedarf zum Durchfahren der einzelnen Kanten (Streckenwiderstand) sowie zum Durchfahren der Knotenbereiche jeweils vom Ende jeder dort eintreffenden zum Anfang jeder dort abgehenden Kante (Abbiegewiderstand) dar.

Jeder Kante des Netzes wird für beide Richtungen ein summierter Zeitbedarf bis zum Ziel (Zielwiderstand) und Optimal-Nachfolger (Nummer der nachfolgenden zum Ziel führenden Kante) zugeordnet. Es werden zwei Listen zur Vormerkung der im nächsten Verfahrensschritt zu bearbeitenden Kantennummern geführt.

Beim Startschritt werden die Zielwiderstände aller Kanten des Netzes mit dem größten darstellbaren Wert besetzt. Der Zielwiderstand der Zielkante wird mit null besetzt. Die Nummer der Zielkante wird in einer ersten Liste notiert.

Im ersten Schritt werden die Zielwiderstände aller Vorgänger von allen in der ersten Liste aufgeführten Kanten mit den Widerstandswerten verglichen, die sich als Summe des Zielwiderstands der jeweiligen in der ersten Liste notierten Kante und den dazugehörigen Abbiege und Streckenwiderständen ergeben. Ist diese Summe kleiner, so wird sie als neuer Zielwiderstand des jeweiligen Vorgängers notiert und die Nummer dieses Vorgängers in einer zweiten Liste abgespeichert.

In einem zweiten Schritt wird überprüft, ob die zweite Liste leer ist. Trifft dies zu, so ist die Routensuche abgeschlossen, andernfalls werden alle in der zweiten Liste aufgeführten Kantennummern zur ersten Liste übertragen und das Verfahren mit dem ersten Schritt fortgesetzt.

Das beschriebene Verfahren funktioniert auch dann, wenn es mit mehr als einer Zielkante initialisiert wird. Es führt dann immer zum am schnellsten erreichbaren Ziel. Wird ein Zielwiderstand eines Zieles nicht mit Null, sondern einem beliebigen endlichen Widerstand initialisiert, so wird dies Ziel gegenüber dem anderen entsprechend der dort verwendeten Startwerte bevorzugt oder benachteiligt.

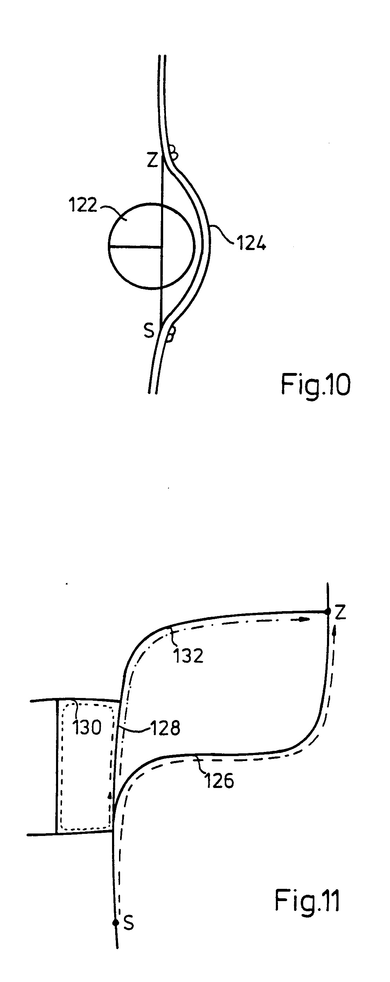

Fig. 10 zeigt zur Veranschaulichung der Festlegung von Widerstandswerten einen Ausschnitt aus einem Straßennetz mit einem Stadtbereich 122 und einem Fernstraßenbereich 124. Vom Startpunkt S zum Zielpunkt Z können sowohl Straßen des Stadtbereiches 122 als auch des Fernstraßenbereichs 124 ausgewählt werden. Bei der Abspeicherung des Straßennetzes werden die Straßen mit entsprechenden Widerstandswerten initialisiert. Dabei erhalten die Straßen des Stadtbereichs 122 einen hohen und diejenigen des Fernstraßenbereichs 124 einen niedrigen Widerstandswert zugeordnet. Diese Widerstandswerte werden dann bei der Auswahl der Fahrtroute berücksichtigt.

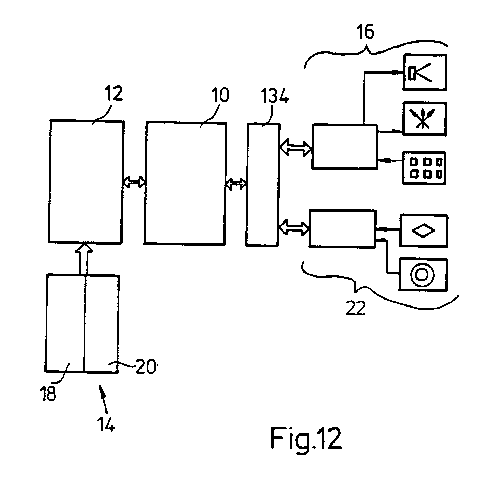

Fig. 11 zeigt eine Darstellung einer Fahrtroutenkorrektur. Zweckmäßig wird die ist-Position des Fahrzeugs ständig durch Fahrdatengeber ermittelt und dem Fahrer über ein Display oder eine Ansagevorrichtung Hinweise gegeben. Es wird angenommen, daß auf dem Weg vom Startpunkt S zum Zielpunkt Z die Empfehlung gegeben wird, der Straße 126 zu folgen. Fährt der Fahrer geradeaus die Straße 128, erfolgt ein Alarmsignal und es wird eine Entscheidung dahingehend abgerufen, ob ein "Fahrfehler" vorliegt oder eine "absichtliche Routenänderung" vorgenommen wurde.

Wird der erste Fall bestätigt, so erfolgt Fahrtroutenberechnung im unveränderten Netz.

Im zweiten Fall wird der Widerstandswert der Straße 126 stark erhöht, so daß dieser nicht mehr bei der Routenauswahl berücksichtigt wird.

In den Fällen, in denen die Betätigung der Eingabeeinheit unterbleibt, wird der Widerstandswert des empfohlenen aber nicht gefahrenen Routenabschnitts automatisch schrittweise erhöht und die Route neu berechnet. Damit wird gewährleistet, daß bei irrtümlichen Abweichen die Möglichkeit einer Rückführung an die Stelle des Abweichens existiert, diese jedoch bei mehrfacher Nichtbefolgung der Empfehlung immer unwahrscheinlicher wird und schließlich entfällt.

Fig. 12 zeigt schließlich noch ein Blockschaltbild einer erfindungsgemäßen Vorrichtung. Diese umfaßt einen Rechner 10 mit einem Arbeitsspeicher 12 und einem Festwertspeicher 14, z.B. in Gestalt einer CD-ROM. Der Rechner 10 ist über ein Interface 134 mit einer Ein-Ausgabe-Einheit 16 sowie einem Fahrdatengeber 22 verbunden.

Im Rechner 10 werden über die Ein-Ausgabe-Einheit 16 die Identifikationen für den Startpunkt und den Zielpunkt im Straßennetz eingegeben. Nun werden aus dem Festwertspeicher 14 die für die Berechnung der Start-Ziel-Beziehung notwendigen Teile der Beschreibung des gespeicherten Straßennetzes von dem Festwertspeicher 14 in den Arbeitsspeicher 12 kopiert. Der Rechner 10 ist nun in der Lage, das vorbeschriebene Verfahren der Routenbestimmung durchzuführen. Nach Durchführung der Berechnung wird eine Reihe von Identifikationen der Straßen über die Ein-Ausgabe-Einheit 16 gegeben, die beginnend mit der Ist-Position als nächstes zu befahren sind, um der berechneten Route zu folgen.

Über die Ein-Ausgabe-Einheit 16 kann das Verfahren auch so beeinflußt werden, daß bei aktuellen Änderungen des Netzes, die nicht in der Beschreibung des Straßennetzes enthalten sind, eine Rückführung an diese Stelle nicht erfolgt. Dies wird dadurch erreicht, daß der einem nicht befahrbaren Straßenabschnitt zugeordnete Widerstandswert wesentlich erhöht und die Routenbestimmung erneut durchgeführt wird.

Zur Speicherung der Netzbeschreibung des Straßennetzes ist der Festwertspeicher 14 in zwei Speicherbereiche 18 und 20 unterteilt. Aufgrund dieser beiden Speicherbereiche ist eine Routenbestimmung in beiden Ebenen und ein Übergang von einer zur anderen Ebene ohne Berechnung der Daten aus einer einzigen gemeinsamen Netzbeschreibung möglich. Im einzelnen umfaßt die Netzbeschreibung für das gesamte Netz nach Teilgebieten unterteilt

- die Beschreibung aller Straßenabschnitte des Netzes,
- den Zusammenhang der Straßenabschnitte untereinander,
- den mittleren Zeitbedarf für das Durchfahren der Straßenabschnitte und der Verbindungen untereinan-

EP 0 323 485 B1

der.
Ferner umfaßt die Netzbeschreibung für alle Teilgebiete des Netzes je
– eine Liste von verkehrstechnish wichtigen Hauptübergängen, die in die benachbarten Teilgebiete führen,
– eine Matrix von Netzwiderständen für die Verbindung der Hauptübergänge eines Teilgebietes untereinander.

**Patentansprüche**

1. Verfahren zur bestimmung einer Fahrtroute zwischen einem Startpunkt (S) und einem Zielpunkt (Z), welche innerhalb eines digital gespeicherten Straßennetzes gelegen sind, dadurch gekennzeichnet, daß das Straßennetz in wenigstens zwei Ebenen (Figur 1, Figur 2) unterschiedlicher Maschendichte und Gebietsgröße zerlegt und gespeichert wird, wobei einer unteren Ebene mehrere kleinere Teilgebiete feiner Maschendichte (24, 26) und einer höheren Ebene ein oder mehrere größere Teilgebiete gröberer Maschendichte (28 bis 42) zugewiesen sind, wobei die Maschen aus Straßen und Knoten gebildet werden, wobei die Knoten in der unteren Ebene Straßenverzweigungen und in den höheren Ebenen Teilgebiete der unteren oder nächstunteren Ebene darstellen wobei innerhalb der unteren Ebene alle befahrbaren Straßen und innerhalb der höheren Ebene die Straßen enthalten sind, die die Teilgebiete der unteren oder nächstunteren Ebene verbinden und wobei den Straßen und Knoten Widerstandswerte in Abhängigkeit der Fahrstrecke und/oder der mittleren Fahrzeit und/oder der Verkehrsdichte zugewiesen werden, und daß die Straßen und Knoten mit dem insgesamt geringsten Widerstandswerten ausgewählt werden, und daß beginnend bei der unteren Ebene das Straßennetz auf eine mögliche Fahrtroute untersucht wird, wobei eine Fahrtroute möglich ist, wenn der Startpunkt (S) und der Zielpunkt (Z) innerhalb desselben Teilgebietes der unteren Ebene gelegen sind, und wenn sie mit einer Straße innerhalb dieses Teilgebietes oder innerhalb dieses und eines angrenzenden Teilgebietes verbunden sind und bei negativen Ergebnissen solange in die nächst höhere Ebene übergegangen wird, bis ein positives Ergebnis erzielt wird, wobei die Fahrtroute innerhalb derselben Ebene oder zwischen den Ebenen in auf- und dann absteigende Folge festgelegt wird.

2. Verfahren nach Anspruch 1, dadurch gekennzeichnet, daß die Route vom Zielpunkt (Z) rückwärts zum Startpunkt (S) bestimmt wird.

3. Verfahren nach Anspruch 2, dadurch gekennzeichnet, daß die Route nach dem umgekehrten Ford-Moore-Algorithmus bestimmt wird.

4. Verfahren nach einem der vorhergehenden Ansprüche, dadurch gekennzeichnet, daß die Teilgebiete des Startpunktes (S) und Zielpunktes (Z) bestimmt werden, daß bei Lage in demselben Teilgebiet die Möglichkeit überprüft wird, den Zielpunkt (Z) vom Startpunkt (S) aus zu erreichen, und daß bei Lage in einem anderen Teilgebiet Widerstandswerte vom Zielpunkt zu den Übergängen des das Ziel umfasssenden Gebietes (Zielgebiet) bestimmt werden (Zielpunkt-Widerstandswerte), die Übergänge mit dem Zielpunkt-Widerstandswerten initialisiert werden, daß bei dem Straßennetz in der höheren Ebene dann Übergangswiderstandsmatrizen gebildet werden und anschließend die Übergänge des den Startpunkt umfassenden Gebietes (Startgebiet) mit den Widerstandswerten des Zielgebietes initialisiert werden (Zielgebiets-Widerstandswerte) und daß danach die Endlichkeit von Widerstandswerten zwischen dem Startpunkt und dem Zielgebiet überprüft wird.

5. Verfahren nach Anspruch 4, dadurch gekennzeichnet, daß bei Erreichbarkeit des Zielpunktes vom Startpunkt in dem selben Teilgebiet die Route festgelegt wird, und daß bei Nichterreichbarkeit der Übergang mit dem geringsten Widerstandswert vom Zielpunkt (Zielpunkt-Widerstand) bestimmt wird, daß das Teilgebiet, das an diesen Übergang angrenzt, und das ursprüngliche Zielgebiet zusammengefaßt werden, daß erneut die Möglichkeit geprüft wird, den Zielpunkt vom Startpunkt zu erreichen, daß bei Erreichbarkeit die Route festgelegt wird, und daß bei Nichterreichbarkeit mit der Bestimmung der Widerstandswerte vom Zielpunkt zu den Übergängen des Zielgebietes fortgefahren wird.

6. Verfahren nach Anspruch 4 oder 5, dadurch gekennzeichnet, daß bei endlichem Widerstandswert zwischen dem Startpunkt und dem Zielgebiet der Übergang des Startgebietes mit dem geringsten Gesamtübergangswiderstand zwischen dem Zielgebiet und dem Startpunkt bestimmt wird, daß das Teilgebiet, das an diesen Übergang angrenzt (Leitgebiet) und das Startgebiet zusammengefaßt werden und die Route

6

festgelegt wird, und daß bei nichtendlichem Widerstandswert zwischen dem Startpunkt und dem Zielgebiet die Übergänge des Startgebietes mit Null initialisiert werden, daß der Übergang bestimmt wird, der den geringsten Widerstandswert vom Startpunkt bietet, und daß mit der Zusammenfassung des an diesem Übergang angrenzenden Teilgebietes und des Startgebietes fortgefahren wird.

7. Verfahren nach einem der vorhergehenden Ansprüche, dadurch gekennzeichnet, daß die Route auf einem Display angezeigt wird.

8. Verfahren nach einem der vorhergehenden Ansprüche, dadurch gekennzeichnet, daß die Route mit aktuellen Fahrdaten verglichen und bei Straßenverzweigungen die empfohlene Fahrtrichtung auf einem Display angezeigt und/oder sprachsynthetisch ausgegeben wird.

9. Verfahren nach einem der vorhergehenden Ansprüche, dadurch gekennzeichnet, daß bei Abweichung von der empfohlenen Fahrtroute Alarm gegeben und eine Abfrage nach "Fahrfehler" oder "absichtliche Routenänderung" aktiviert wird.

10. Verfahren nach Anspruch 9, dadurch gekennzeichnet, daß bei Eingabe "Fahrfehler" die Route weiterhin im unveränderten Netz berechnet wird, und bei Eingabe "absichtliche Routenänderung" die Route neu berechnet wird, nachdem die Straße im Netz gestrichen (mit unendlichem Widerstand versehen) wurde, die als erste der zuletzt auf der berechneten Route befahrenen Straße auf dieser Route folgte.

11. Vorrichtung zur Bestimmung einer Fahrtroute zwischen einem Startpunkt und einem Zielpunkt, welche innerhalb eines digital gespeicherten Straßennetzes gelegen sind, nach einem Verfahren der vorhergehenden Ansprüche bestehend aus einem Rechner (10) mit einem Arbeitsspeicher(12) und einem Festwertspeicher (14) sowie einer Anzeige- und Bedieneinheit (16), dadurch gekennzeichnet, daß der Festwertspeicher (14) unterschiedliche Speicherplätze (18, 20) für wenigstens zwei Ebenen unterschiedlicher Maschendichte und Gebietsgröße des Straßennetzes umfaßt.

12. Vorrichtung nach Anspruch 11, dadurch gekennzeichnet, daß zusätzlich ein Fahrdatengeber (22) vorgesehen ist und mit dem Rechner (10) verbunden ist.

## Claims

1. Process for determining an itinerary between a starting point (S) and a destination point (Z), which are located within a digitally stored road network, characterised in that the road network is divided and stored on at least two levels (Figure 1, Figure 2) of different mesh density and district size, a lower level being allocated a number of smaller sub-districts of fine mesh density (24, 26) and a higher level being allocated one or more larger sub-districts of coarser mesh density (28 to 42), the meshes being formed from roads and nodes, the nodes representing on the lower level road junctions and on the higher levels sub-districts of the lower or next-lower level, all roads which can be travelled along being contained within the lower level and the roads which connect the sub-districts of the lower level or next-lower level being contained within the higher level, and the roads and nodes being allocated resistance values dependent on the distance along the route and/or the average travelling time and/or the traffic density, and in that the roads and nodes having the overall lowest resistance values are selected, and in that, beginning with the lower level, the road network is investigated for a possible itinerary, an itinerary being possible if the starting point (S) and the destination point (Z) are located within the same sub-district of the lower level, and if they are connected by a road within this subdistrict or within this sub-district and an adjacent subdistrict and, in the case of negative results, a crossing is repeatedly made to the next-higher level until a positive result is obtained, the itinerary being fixed within the same level or up and down between levels.

2. Process according to Claim 1, characterised in that the route is determined from the destination point (Z) backwards to the starting point (S).

3. Process according to Claim 2, characterised in that the route is determined on the basis of the inverse Ford-Moore algorithm.

4. Process according to one of the preceding claims, characterised in that the sub-districts of the starting point (S) and destination point (Z) are determined, in that if located in the same sub-district the possibility is checked whether the destination point (Z) can be reached from the starting point (S), and in that if located in a different sub-district resistance values from the destination point to the crossings of the district including the destination (destination district) are determined (destination point resistance values), the crossings are initialised with the destination point resistance values, in that in the case of the road network on the higher level crossing resistance matrices are then formed and subsequently the crossings of the district including the starting point (starting district) are initialised with the resistance values of the destination district (destination district resistance values) and in that thereafter the finiteness of resistance values between the starting point and the destination district is checked.

5. Process according to Claim 4, characterised in that, if the destination point can be reached from the starting point in the same sub-district, the route is fixed, and in that, if it cannot be reached, the crossing having the lowest resistance value from the destination point (destination point resistance) is determined, in that the sub-district which is adjacent to this crossing and the original destination district are combined, in that the possibility of reaching the destination point from the starting point is checked once again, in that, if it can be reached, the route is fixed, and in that, if it cannot be reached, the determination of the resistance values from the destination point to the crossings of the destination district is continued.

6. Process according to Claim 4 or 5, characterised in that, in the case of a finite resistance value between the starting point and the destination district, the crossing of the starting district having the lowest overall crossing resistance between the destination district and the starting point is determined, in that the sub-district which is adjacent to this crossing (directing district) and the starting district are combined and the route is fixed, and in that, in the case of a non-finite resistance value between the starting point and the destination district, crossings of the starting district are initialised with zero, in that the crossing which offers the lowest resistance value from the starting point is determined, and in that the combining of the sub-district adjacent to this crossing and the starting district is continued.

7. Process according to one of the preceding claims, characterised in that the route is indicated on a display.

8. Process according to one of the preceding claims, characterised in that the route is compared with current driving data and, in the case of road junctions, the recommended travelling direction is indicated on a display and/or is output by voice synthesis.

9. Process according to one of the preceding claims, characterised in that, in the case of a deviation from the recommended itinerary, an alarm is given and an inquiry as to "driving error" or "intentional change of route" is activated.

10. Process according to Claim 9, characterised in that, if "driving error" is entered, the route continues to be calculated in the unchanged network, and, if "intentional change of route" is entered, the route is recalculated once the road which was the first to follow on the calculated route the road last travelled along on the said route has been cancelled in the network (provided with infinite resistance).

11. Apparatus for determining an itinerary between a starting point and a destination point, which are located within a digitally stored road network, by a process of the preceding claims, comprising a computer (10) having a main memory (12) and a read-only memory (14) as well as a display and operator control unit (16), characterised in that the read-only memory (14) comprises different memory locations (18, 20) for at least two levels of different mesh density and district size of the road network.

12. Apparatus according to Claim 11, characterised in that a driving data sensor (22) is additionally provided and connected to the computer (10).

**Revendications**

1°) Procédé pour la détermination d'un itinéraire entre un point de départ (S) et un point de destination (Z), qui sont situés à l'intérieur d'un réseau routier mémorisé numériquement, procédé caractérisé en ce que le réseau routier est décomposé et mémorisé en au moins deux plans (figure 1, figure 2) de densités de mailles et de grandeurs de territoire différentes, plusieurs territoires partiels plus petits de fine densité de mailles (24, 26) étant affectés à un plan inférieur et un ou plusieurs territoires partiels de densité de mailles plus grossière (28 à 42) étant affectés à un plan plus élevé, tandis que les mailles sont constituées de routes et de noeuds, les noeuds représentant dans le plan inférieur des branchements routiers et dans les plans supérieurs des territoires partiels du plan inférieur ou immédiatement inférieur, et dans le plan inférieur sont comprises toutes les routes praticables et dans le plan le plus élevé les routes qui relient les territoires partiels du plan inférieur ou immédiatement inférieur, et aux routes et aux noeuds routiers sont affectées des valeurs de résistance en fonction du parcours et/ou du temps de parcours moyen et/ou de la densité du trafic, et en ce que les routes et les noeuds routiers comportant les valeurs de résistance au total les plus réduites sont sélectionnés, et en ce que, en commençant par le plan inférieur, un itinéraire possible est recherché, un itinéraire étant possible lorsque le point de départ (S) et le point de destination (Z) se situent dans le même territoire partiel du plan inférieur, et lorsqu'ils sont reliés par une route dans ce territoire partiel ou dans celui-ci et un territoire partiel contigu, et dans le cas de résultats négatifs, on passe au plan immédiatement plus élevé, jusqu'à ce qu'un résultat positif soit obtenu, l'itinéraire étant déterminé dans ces mêmes plans ou entre les plans en succession ascendante et ensuite descendante.

2°) Procédé selon la revendication 1, caractérisé en ce que l'itinéraire est déterminé depuis le point de destination (Z) en revenant vers le point de départ (S).

3°) Procédé selon la revendication 2, caractérisé en ce que l'itinéraire est déterminé selon l'algorithme Ford-Moore inversé.

4°) Procédé selon une des précédentes revendications, caractérisé en ce que les territoires partiels du point de départ (S) et du point de destination (Z) sont déterminés, en ce que si ces points se situent dans le même territoire partiel il est vérifié que le point de destination (Z) peut être atteint à partir du point de départ (S), et en ce que, si ces points se situent dans des territoires partiels différents, les valeurs de résistance depuis le point de destination vers les passages du territoire incluant la destination (territoire de destination) sont déterminées (valeurs de résistance du point de destination) et les passages sont initialisés avec les valeurs de résistance du point de destination, en ce que pour le réseau routier dans le plan supérieur des matrices de résistance de passage sont alors formées et ensuite les passages du territoire incluant le point de départ (territoire de départ) sont initialisés avec les valeurs de résistance du territoire de destination (valeurs de résistance du territoire de destination), et en ce qu'ensuite la finitude des valeurs de résistance entre le point de départ et le territoire de destination est vérifiée.

5°) Procédé selon la revendication 4, caractérisé en ce que, lorsqu'il est possible d'atteindre le point de destination à partir du point de départ dans le même territoire partiel, l'itinéraire est fixé, et en ce que, lorsque cela n'est pas possible, le passage est déterminé avec la valeur de résistance la plus réduite à partir du point de destination (résistance du point de destination), en ce que le territoire partiel qui est contigu à ce passage et le territoire de destination d'origine sont rassemblés, en ce que la possibilité d'atteindre le point de destination à partir du point de départ est à nouveau vérifiée, en ce que dans le cas où il peut être atteint, l'itinéraire est fixé, et en ce que, dans le cas où il ne peut être atteint, on continue avec la détermination des valeurs de résistance depuis le point de destination jusqu'aux passages du territoire de destination.

6°) Procédé selon la revendication 4 ou 5, caractérisé en ce que pour la valeur de résistance terminale entre le point de départ et le territoire de destination, le passage du territoire de départ est déterminé avec la résistance totale de passage la plus réduite entre le territoire de destination et le point de départ, en ce que le territoire partiel, qui est contigu à ce passage (territoire pilote) et le territoire de départ sont assemblés et l'itinéraire est fixé, et en ce que, pour une valeur de résistance non terminale entre le point de départ et le territoire de destination, les passages du territoire de départ sont initialisés avec zéro, et le passage qui offre la valeur de résistance la plus réduite à partir du point de départ est déterminé, et en ce que on continue avec le rassemblement du territoire partiel contigu à ce passage et du territoire de départ.

7°) Procédé selon une quelconque des précédentes revendications, caractérisé en ce que l'itinéraire est indiqué sur un affichage.

8°) Procédé selon une des précédentes revendications, caractérisé en ce que l'itinéraire est comparé avec des données de route actuelles et dans le cas d'embranchements routiers, la direction de déplacement recommandée est indiquée sur un affichage et/ou donnée par synthèse de la parole.

9°) Procédé selon une des précédentes revendications, caractérisé en ce que, lorsqu'on s'écarte de l'itinéraire routier recommandé, l'alarme est donnée et une interrogation quant à une "erreur de route" ou une "modification intentionnelle d'itinéraire" est déclenchée.

10°) Procédé selon la revendication 9, caractérisé en ce que, lors de l'entrée "erreur de route" l'itinéraire continue à être calculé dans le réseau non modifié, et que lors de l'entrée "modification intentionnelle d'itinéraire", l'itinéraire est calculé à nouveau, après qu'ait été rayée dans le réseau (affectée d'une résistance infinie) la route suivie sur cet itinéraire en tant que première des routes empruntées en dernier lieu sur l'itinéraire calculé.

11°) Dispositif pour déterminer un itinéraire entre un point de départ et un point de destination qui sont situés dans un réseau routier mémorisé numériquement, selon un procédé des précédentes revendications,

9

dispositif constitué par un calculateur (10) avec une mémoire centrale (12) et une mémoire fixe (14) ainsi qu'avec une unité (16) d'indication et de commande, dispositif caractérisé en ce que la mémoire fixe (14) comprend différentes places de mémoire (18, 20) pour au moins deux plans, de densité de mailles différente et de grandeur de territoire différente, du réseau routier.

12°) Dispositif selon la revendication 11, caractérisé en ce qu'il est prévu en outre un émetteur de données de route (22) qui est relié au calculateur.

Fig.1

Fig.2

Fig.3

Start —52

Teilgebiete
von Start-
und Zielpunkt —54

selbes —56
Teilgebiet  nein →                                    86

Widerstandswerte zwischen
Zielpunkt und Übergängen Zielgebiet —68

ja

Zielpunkt —58
erreichbar?  nein

Initialisierung der Übergänge
Zielgebiet —70

ja

62—Übergang mit geringstem
Zielpunktwiderstandswert

Übergangswiderstandsmatrizen
in übergeordneter Ebene —72

64—Zusammenfassung
angrenzendes Teilgebiet
mit Zielgebiet

Initialisierung der Übergänge
Startgebiet —74

66—Zielpunkt
erreichbar?  nein

Widerstandswert —76
zwischen Start- und Zielgebiet  nein
endlich?

ja

90

78—Übergang des geringsten Gesamtwiderstandswerts zwischen
Zielgebiet und Startpunkt

Initialisierung der Übergänge
Startgebiet "Null" —82

Übergang des geringsten
Widerstandswerts zum
Startpunkt —84

88

80—Zusammenfassung
Leitgebiet mit
Startgebiet

Fig. 4

92

Routenfestlegung —60

12

Fig.5

94    96  100    98

Fig.6

102    114    108

114

104    110

116

106    112

120

118

Fig.7

102    Z    108

104    110

106    S    112

Fig.8

Vorgänger    a:  b,c,j
─────────────────────────────────────────

b:  a,h,p
c:  d,e,l
j:  i,k,m,o
─────────────────────────────────────────

h:  f,g,n
p:  i,k,m,o
d:  b,c,j
e:  f,g,n
l:  i,k,m,o
i:  b,c,j
k:  d,e,l
m:  f,g,n
o:  a,h,p
─────────────────────────────────────────

f:  d,e,l
g:  a,h,p
n:  i,k,m,o

| Kante | Zielwiderstand | optimaler Nachfolger |
|-------|----------------|----------------------|
| a | 0 | - |
| b | 1 | a |
| c | 1 | a |
| d | 2 | c |
| e | 2 | c |
| f | 3 | h |
| g | 3 | h |
| h | 2 | b |
| i | 2 | j |
| j | 1 | a |
| k | 2 | j |
| l | 2 | c |
| m | 2 | j |
| n | 3 | h |
| o | 2 | j |
| p | 2 | b |

Fig.9

14

Fig.10

Fig.11

Fig.12